# EUROPÄISCHE PATENTANMELDUNG

(11) **EP 0 889 490 A2**
(43) Veröffentlichungstag der Anmeldung: **07.01.1999**
(21) Anmeldenummer: 98119506.8
(22) Anmeldetag: 08.08.1995
(51) Int. Cl.: H01F 38/30

(54) **Stromwandler für eine metallgekapselte Gasisolierte Hochspannungsanlage**

(30) Priorität: 24.08.1994 DE 4429959
(62) Teilanmeldung aus: 95810499.4
(71) Anmelder: Asea Brown Boveri AG, 5401 Baden (CH)
(72) Erfinder: Kaczkowski, Andrzej Dr., 5303 Würenlingen (CH)
(74) Vertreter: Kaiser, Helmut

(57) **Zusammenfassung**

Dieser Stromwandler ist insbesondere für eine metallgekapselte, gasisolierte Hochspannungsanlage vorgesehen. Er weist einen torusförmig ausgebildeten, eine Strombahn umschliessenden Stromsensor und eine diesem nachgeschaltete Signalverarbeitungsvorrichtung auf. Der Stromsensor ist von einer Abschirmung umgeben, die einen ringförmigen, mit einer Masse (4) aufgefüllten Hohlraum einschliesst.

Es soll ein Stromwandler für metallgekapselte gasisolierte Hochspannungsanlagen geschaffen werden, welcher auch gegen hochfrequente elektrische Störungen unempfindlich ist, welcher kostengünstig zu erstellen ist, und welcher sich durch geringe Abmessungen und durch eine hohe Messgenauigkeit auszeichnet. Dies wird dadurch erreicht, dass die Abschirmung als mindestens eine elektrisch leitende oder halbleitende, mindestens eine Lage aufweisende Folie ausgebildet ist, welche beim Auftreffen von hochfrequenten Störungen diese von dem Stromsensor fern hält.

## Beschreibung

### TECHNISCHES GEBIET

Bei der Erfindung wird ausgegangen von einem Stromwandler für eine metallgekapselte gasisolierte Hochspannungsanlage gemäss dem Oberbegriff des Anspruchs 1.

### STAND DER TECHNIK

Die Erfindung nimmt dabei Bezug auf einen Stand der Technik, wie er sich beispielsweise aus der Schrift EP-A2-0 522 303 ergibt. Der dort beschriebene kombinierte Messwandler ist für eine metallgekapselte, gasisolierte Hochspannungsanlage bestimmt. Er weist einen Strom- und Spannungssensor und eine dem Strom- und Spannungssensor nachgeschaltete Signalverarbeitungsvorrichtung auf. Als Stromsensor dient eine Rogowskispule, die um einen ringförmigen Kern aus nicht ferromagnetischem, überwiegend isotropem Material gewickelt ist. Als Spannungssensor ist eine hohlzylindrisch ausgebildete Messelektrode vorgesehen. Nach dem Einbau des Strom- und Spannungssensors in die Metallkapselung umgeben die Spule und die Messelektrode einen Stromleiter der gasisolierten Schaltanlage konzentrisch.

Die Rogowskispule ist in einen ringförmigen Isolierkörper eingebettet, der in einem ringförmigen Raum angeordnet ist. Die Wände des Raums bestehen aus elektrisch leitendem Material, vorzugsweise aus einer Aluminiumlegierung. Der Isolierkörper ist in diesem Raum fixiert. Der Raum ist an seiner dem Stromleiter zugewandten Mantelfläche von einer flächenhaften, ringförmigen Abschirmelektrode begrenzt. Die eine Stirnseite dieser Abschirmelektrode ist in elektrisch leitender Weise mit der Wand auf der einen Seite des ringförmigen Raums verbunden, während die dieser gegenüberliegende Stirnseite in elektrisch isolierender Weise mit der Wand auf der anderen Seite des ringförmigen Raums verbunden ist. Als isolierende Verbindung ist hier ein vergleichsweise schmaler, vollständig mit Isoliermaterial gefüllter Spalt vorgesehen. Die Wände des ringförmigen Raumes bilden mit der Abschirmelektrode eine elektrisch leitende Abschirmung. Diese Abschirmung schützt den ringförmigen Raum vor dem Einfluss elektrischer Störfelder. Beim Messen in der Hochspannungsanlage unter Betriebsbedingungen werden daher von der Rogowskispule Signale abgegeben, die frei sind von Beeinflussungen durch die elektrischen Störfelder. Die Rogowskispule liefert dem Betrag und der zeitlichen Änderung des im Stromleiter der gasisolierten Schaltanlage fliessenden Stromes proportionale Signale, welche aufgrund der geeignet angeordneten Abschirmung nahezu frei von den Einflüssen elektrischer Fremdfelder sind. Für viele praktische Anwendungen dürfte ein derart aufgebauter Stromwandler durchaus genügen.

Der mit Isoliermaterial gefüllte Spalt in der die Rogowskispule umgebenden Abschirmung ist jedoch die Ursache dafür, dass schnelle und sehr schnelle transiente elektrische Störungen, etwa in einem Frequenzbereich von grösser als 1 MHz bis etwa mehrere GHz, nicht von der Rogowskispule ferngehalten werden. Derartige Störungen verfälschen das Messignal, sie können zudem die Ursache dafür sein, dass der stets vorhandene Überspannungsschutz am Eingang der Signalverarbeitungsvorrichtung überbeansprucht wird.

### DARSTELLUNG DER ERFINDUNG

Der Erfindung, wie sie in den unabhängigen Patentansprüchen angegeben ist, liegt die Aufgabe zugrunde, einen Stromwandler für metallgekapselte gasisolierte Hochspannungsanlagen anzugeben, welcher gegen hochfrequente elektrische Störungen unempfindlich ist, welcher kostengünstig zu erstellen ist, und welcher sich durch geringe Abmessungen und durch eine hohe Messgenauigkeit auszeichnet.

Der Stromwandler nach der Erfindung zeichnet sich dadurch aus, dass er gegen hochfrequente Störungen geschützt ist. Der Stromwandler weist einen torusförmig ausgebildeten, eine Strombahn umschliessenden Stromsensor und eine diesem nachgeschaltete Signalverarbeitungsvorrichtung auf. Er weist ferner einen den Stromsensor umgebenden und von einer Abschirmung eingeschlossenen ringförmigen Hohlraum auf, der mit einer Masse aufgefüllt ist. Die Abschirmung ist als mindestens eine elektrisch leitende oder halbleitende mindestens eine Lage aufweisende Folie ausgebildet. Dieser Stromwandler ist insbesondere für metallgekapselte, gasisolierte Hochspannungsanlagen die vergleichsweise weniger intensiven hochfrequenten Störungen unterworfen sind, geeignet, er ist kostenmässig besonders günstig herzustellen, zudem ist er besonders einfach in die Anlagen einzubauen, da er einen geringen Platzbedarf aufweist.

Die weiteren Ausgestaltungen der Erfindung sind Gegenstände der abhängigen Ansprüche.

Die Erfindung, ihre Weiterbildung und die damit erzielbaren Vorteile werden nachfolgend anhand der Zeichnung, welche lediglich einen möglichen Ausführungsweg darstellt, näher erläutert.

### KURZE BESCHREIBUNG DER ZEICHNUNG

Es zeigen:
Fig.1 einen Schnitt durch einen schematisch dargestellten Stromwandler, welcher als Stand der Technik betrachtet wird, und
Fig.2 einen Schnitt durch eine schematisch dargestellte Ausführungsform eines erfindungsgemässen Stromwandlers.

Bei beiden Figuren sind gleich wirkende Elemente mit gleichen Bezugszeichen versehen. Alle für das unmittelbare Verständnis der Erfindung nicht erforderlichen Elemente sind nicht dargestellt.

### WEGE ZUR AUSFÜHRUNG DER ERFINDUNG

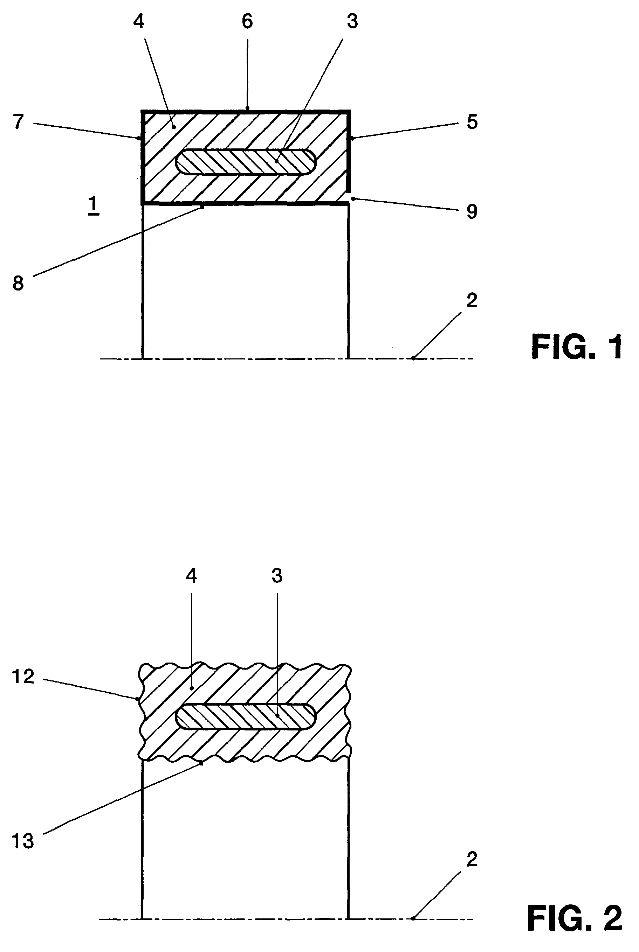

Die Fig.1 zeigt einen Schnitt durch einen schematisch dargestellten, ringförmig ausgebildeten Stromwandler 1, welcher als Stand der Technik betrachtet wird. Dieser Stromwandler 1 umgibt einen Stromleiter der metallgekapselten gasisolierten Schaltanlage konzentrisch. Von diesem Stromleiter ist lediglich die Mittelachse 2 dargestellt, die bei einer einphasig metallgekapselten gasisolierten Schaltanlage gleichzeitig die Mittelachse der Metallkapselung ist. Als Stromsensor dient hier eine Rogowskispule 3, die um einen ringförmigen, nicht bezeichneten Kern aus nicht ferromagnetischem, überwiegend isotropem Material gewickelt ist. Es können jedoch auch andere torusförmig ausgebildete Stromsensoren an dieser Stelle eingesetzt werden. Die von der Rogowskispule 3 weg in eine nicht dargestellte Signalverarbeitungsvorrichtung führenden Signalleitungen sind ebenfalls nicht dargestellt. Die Rogowskispule 3 ist in einem mit einer elektrisch isolierenden Masse 4 aufgefüllten, ringförmig ausgebildeten Hohlraum mit rechteckigem Querschnitt angeordnet. Die Begrenzung des Hohlraums erfolgt durch als Abschirmung wirkende elektrisch leitende Wände 5,6,7,8, die durch Linien angedeutet sind, die eine etwas grössere Strichdicke aufweisen. Die konstruktive Ausbildung der die Wände 5,6,7,8 bildenden Bauelemente soll hier nicht näher beschrieben werden. Diese Bauelemente können beispielsweise ähnlich ausgebildet sein, wie in der Schrift EP-A2-0 522 303 dargestellt. Ist in der metallgekapselten gasisolierten Schaltanlage mehr als ein Stromleiter vorgesehen, so umgeben die Stromwandler und die eventuell mit diesen verbundenen Spannungssensoren den jeweils zugeordneten Stromleiter zwar konzentrisch, weisen dann jedoch nicht die gleiche Mittelachse auf wie die Metallkapselung.

Zwischen der Wand 8 und der Wand 5 verbleibt bei dieser Ausführung des Stromwandlers 1 ein vergleichsweise schmaler Spalt 9, der um den gesamten Umfang dieses Stromwandlers 1 herumläuft. Dieser Spalt 9 ist ebenfalls mit der isolierenden Masse 4 ausgefüllt. Durch den Spalt 9 wird verhindert, dass durch die Abschirmung induzierte Streuströme fliessen können, wodurch das die Rogowskispule 3 durchsetzende magnetische Feld verfälscht würde, was zu einer Beeinträchtigung der Messgenauigkeit des Stromwandlers führen würde. Wenn die Abschirmung elektrisch leitend mit der metallischen Kapselung der gasisolierten Schaltanlage verbunden ist, verhindert der Spalt 9 zudem, dass Teile des durch die Metallkapselung der gasisolierten Schaltanlage fliessenden Kapselungsstroms, durch die Wand 8 fliessen können, was ebenfalls eine Beeinträchtigung der Messgenauigkeit des Stromwandlers zur Folge hätte. Die Metallwände des Spalts 9 sollen zudem ein Eindringen von elektrischen Störfeldern in den unmittelbaren Bereich der Rogowskispule 3 verhindern. Schnelle und sehr schnelle transiente elektromagnetische Störungen, etwa in einem Frequenzbereich von grösser als 1 MHz bis etwa mehrere GHz, werden dadurch jedoch nicht von der Rogowskispule ferngehalten.

Die Fig.2 zeigt einen Schnitt durch eine schematisch dargestellte Ausführungsform eines erfindungsgemässen Stromwandlers 1. Bei diesem Stromwandler 1 ist der die Rogowskispule 3 umgebende ringförmige Hohlraum vollständig mit der isolierenden Masse 4 ausgefüllt. Die Aussenseiten der isolierenden Masse 4 sind vollständig mit einer durch eine Schlangenlinie dargestellten, elektrisch leitenden Metallfolie 12 überzogen, ein Spalt ist hier nicht vorgesehen. Die Dicke der Metallfolie 12 wird abhängig von der Leitfähigkeit des für sie verwendeten Materials bestimmt, für gut leitende Metalle wie beispielsweise Ag, Cu oder Al und Legierungen auf der Basis dieser Metalle beträgt sie etwa 3,5 µm, für Ti oder Konstantan beträgt sie etwa 80 µm und für eine Chromnickellegierung 80/20 beträgt sie etwa 180 µm. Diese Dicke hängt ab von der Eindringtiefe hochfrequenter Ströme in das jeweilige Metall. Dieser Stromwandler braucht beim Einbau in die metallgekapselte gasisolierte Schaltanlage nicht von der metallischen Kapselung isoliert werden, da die Metallfolie 12, welche die innere Oberfläche 13 des Stromwandlers 1 bildet, einen solch geringen Querschnitt und damit eine so geringe Stromtragfähigkeit aufweist, dass der durch sie im Normalbetrieb fliessende Strom keine nennenswerte Verfälschung des durch die Rogowskispule 3 aufgenommenen Messwertes verursachen kann. Dieser Stromwandler 1 kann sehr einfach und kostengünstig hergestellt werden und kann ohne aufwendige Einbauarmaturen in jede metallgekapselte gasisolierte Schaltanlage eingebaut werden.

Im Normalbetrieb der Schaltanlage schirmt die dünne Metallfolie 12 die auf die Rogowskispule 3 einwirkenden elektrischen Felder nicht ab, da in diesem Fall ihre elektrische Leitfähigkeit zu gering ist, sodass eine korrekte Strommessung gewährleistet ist. Wird die Schaltanlage und mit ihr die Rogowskispule 3 mit hochfrequenten Störungen beaufschlagt, so schirmt die entsprechend dimensionierte Metallfolie 12 die Rogowskispule 3 ab, sodass deren Strommessungen durch diese Störungen nicht verfälscht werden können.

Statt einer Metallfolie kann jedoch auch eine leitende oder halbleitende Folie aus einem entsprechenden Kunststoff verwendet werden. Diese Folien können einlagig oder mehrlagig ausgeführt sein, wobei bei der mehrlagigen Ausführung die einzelnen Lagen unterschiedlich zusammengesetzt sein können. Durch diese Möglichkeit kann die Wirksamkeit der Abschirmung optimal an die an den Stromwandler 1 gestellten Betriebsanforderungen, insbesondere jedoch an die in der jeweiligen metallgekapselten gasisolierten Schaltanlage zu erwartenden hochfrequenten Störungen, angepasst werden, sodass die Beeinflussung seiner Messgenauigkeit durch diese Störungen vernachlässigt werden kann.

Stromwandler, die entsprechend dem hier beschriebenen Prinzip aufgebaut sind, lassen sich, entsprechend modifiziert, auch in Freiluftschaltanlagen, die für hohe und höchste Betriebsspannungen ausgelegt sind, und in Mittelspannungsanlagen einsetzen, insbesondere sind sie auch in Schaltanlagen einsetzbar, die mit vergleichsweise grossen Strömen betrieben werden. Ferner lassen sich derartige Stromwandler mit vergleichsweise geringem Aufwand mit kapazitiven Spannungswandlern kombinieren, sodass ein einfach und günstig herzustellender kombinierter Strom- und Spannungswandler entsteht. Für metallgekapselte, gasisolierte Hochspannungsschaltanlagen sind derartige kombinierte Strom- und Spannungswandler besonders geeignet, da sie vergleichsweise geringe Abmessungen aufweisen.

### BEZUGSZEICHENLISTE

- 1: Stromwandler
- 2: Mittelachse
- 3: Rogowskispule
- 4: Masse
- 5,6,7,8: Wände
- 9: Spalt
- 11: halbleitende Masse
- 12: Metallfolie
- 13: innere Oberfläche

## Patentansprüche

1. Stromwandler, insbesondere für eine metallgekapselte, gasisolierte Hochspannungsanlage, mit einem torusförmig ausgebildeten, eine Strombahn umschliessenden Stromsensor und mit einer diesem nachgeschalteten Signalverarbeitungsvorrichtung, mit einem den Stromsensor umgebenden und von einer Abschirmung eingeschlossenen ringförmigen Hohlraum, der mit einer Masse (4) aufgefüllt ist, dadurch gekennzeichnet,
- dass die Abschirmung als mindestens eine elektrisch leitende oder halbleitende mindestens eine Lage aufweisende Folie ausgebildet ist.

2. Stromwandler nach Anspruch 1, dadurch gekennzeichnet,
- dass die mindestens eine elektrisch leitende oder halbleitende Folie aus einem Metall oder einer Metallegierung oder einem entsprechend dotierten Kunststoff besteht.

3. Stromwandler nach Anspruch 1 oder 2, dadurch gekennzeichnet,
- dass als Stromsensor mindestens eine Rogowskispule (3) vorgesehen ist.
